Europäisches Patentamt

European Patent Office

Office européen des brevets

(11) Publication number: **0 384 479**
**A2**

## EUROPEAN PATENT APPLICATION

(21) Application number: 90103550.1

(22) Date of filing: 23.02.90

(51) Int. Cl.5: **H01L 39/24, H01L 39/12**

(30) Priority: 24.02.89 US 314852

(43) Date of publication of application:
**29.08.90 Bulletin 90/35**

(84) Designated Contracting States:
**BE CH DE ES FR GB IT LI NL SE**

(71) Applicant: **FMC CORPORATION**
**200 East Randolph Drive**
**Chicago Illinois 60601(US)**

(72) Inventor: **Wilson, Charles N.**
**15340 - 76th Avenue North**
**Maple Grove Minnesota 55369(US)**
Inventor: **French, Steven M.**
**5101 Edgewood Drive**
**Mounds View Minnesota 55112(US)**

(74) Representative: **Bardehle, Heinz, Dipl.-Ing. et al**
**Patent- und Rechtsanwälte**
**Bardehle-Pagenberg-Dost-Altenburg-Frohwi-tter-Geissler & Partner Postfach 86 06 20**
**D-8000 München 86(DE)**

(54) **Method for orienting anisotropic superconducting crystals in a metal matrix composite.**

(57) A method for orienting superconducting crystals by use of an intense magnetic field. The magnetic field orients ceramic crystals which are encapsulated in a powdered metal. The mixture is compressed and heated to fix the oriented ceramic crystals in a position of maximum current carrying capacity.

FIG _ 1

# METHOD FOR ORIENTING ANISOTROPIC SUPERCONDUCTING CRYSTALS IN A METAL MATRIX COMPOSITE

## BACKGROUND OF THE INVENTION

The present invention pertains to superconductors, and more particularly, to superconductor metal metal matrix composites and methods of increasing the conductivity of the composites.

The present invention discloses a method of increasing the current carrying capacity of the superconductive metal matrix composites disclosed in the copending United States patent application entitled "Superconductive Metal Matrix Composites And Method for Making Same" filed October 17, 1988, Serial No. 07/258,533 by Charles N. Wilson and assigned to the assignee of the present invention.

Recent discoveries of ceramic oxide superconductive materials has significantly raised the critical temperature of superconductors and decreased the cost of the coolant material needed to cool the superconductors below the critical temperature. A disadvantage of the various ceramic oxide materials is that they are brittle and breakable when fire hardened which limits the forms in which they can be shaped after firing. Also, the critical current density of these composites is not high enough to make them commercially useful in large current devices operating at temperatures near the superconducting critical temperature. One factor which contributes to the problem of low current is the anisotropy of the superconducting crystals.

## SUMMARY OF THE INVENTION

The present invention discloses the method of increasing the current carrying capacity of a superconductive metal matrix composite, where the composite includes a metal particulate having a superconductive particulate dispersed throughout the metal particulate. The metal matrix composite is formed from a superconducting ceramic powder which is thoroughly mixed with a metal powder. The ceramic powder is composed of crystals that are anisotropic. When a magnetic field is applied to the powder mixture, the ceramic grains are aligned with their crystallographic "C" directions parallel to the applied field. The "C" direction is also the direction of lowest critical current density and shortest grain dimension. The crystallographic "a-b" plane has the greatest critical current density and the longest grain dimension and is perpendicular to the "C" direction. The powder mixture, having oriented ceramic grains, is then heated and compressed to lock the ceramic grains in the matrix metal such that the "a-b" planes of the ceramic grains are parallel to one another.

## BRIEF DESCRIPTION OF THE DRAWINGS

Figure 1 is a perspective of a crystal of superconductive material accompanied by an arrow pointing in the direction of the lowest critical current density.

Figure 2 is a cross-sectional view of a conductor having unoriented ceramic particles dispersed in a metal powder.

Figure 3 is a cross-sectional view of the conductor of Figure 2 with the ceramic particles highly oriented by a magnetic field.

Figure 4 is a cross-sectional view of the conductor of Figure 3 with highly oriented ceramic particles in a densified metal matrix.

## DESCRIPTION OF THE PREFERRED EMBODIMENT

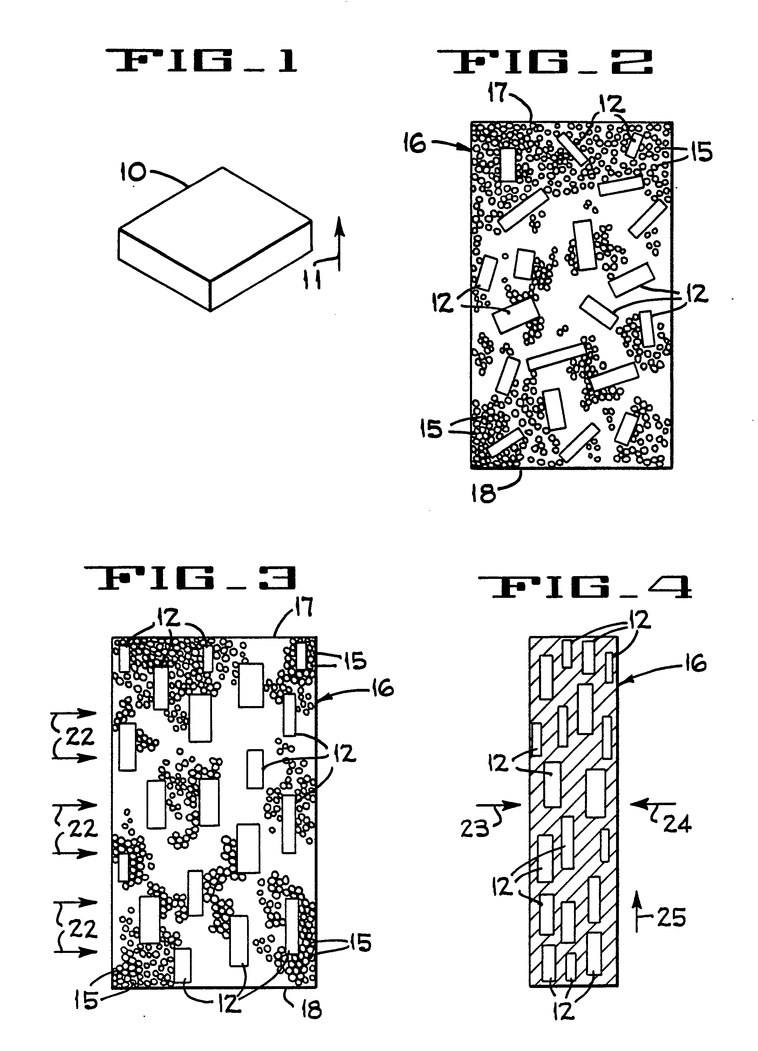

A single crystal 10 of a superconductive ceramic material and an arrow 11 showing the direction of the lowest critical current density and the greatest magnetic susceptibility in the crystal are disclosed in Figure 1. The direction of the greatest critical current density coincides with the longest dimension of the crystal. When an electrical potential is applied to ends of the crystal the current in the long dimension of the crystal is several orders of magnitude larger than a current across the width of the crystal when a potential is applied to the sides of the crystal.

When a superconductor is formed by mixing a superconductive particulate with a metal particulate a plurality of ceramic particles 12 are oriented in a random fashion in a loose metal powder 15 as shown in a conductor 16 of Figure 2. When an electrical potential is applied between a top portion 17 and a bottom portion 15 of conductor 16, an electrical current may follow a wandering, nonuniform path between portions 17 and 18. The result is a relatively high electrical resistance and a relatively low value of electrical current when the superconductor is below the critical temperature.

When a magnetic field is applied to conductor 16 in a direction shown by arrows 22 (Fig. 3) the ceramic particles 12 are aligned in a vertical orientation. This alignment reduces the distances between adjacent ends of ceramic particles 12 and aligns particles 12 so the electrical current readily flows through the long dimension of the particles 12. This alignment greatly reduces the electrical resistance of conductor 16 and facilitates increased current flow through the conductor in the super conducting state in the direction shown by arrow 25 (Fig. 4).

The vertical alignment of ceramic particles 12 can be maintained by compressing and heating the mixture 12, 15 of conductor 16 (Fig. 4). The pressure to compress the mixture is applied in the directions represented by a pair of arrows 23, 24 shown in Figure 4. The pressure and heat compact the particles 12 of the metal powder to produce a dense metal matrix composite. The compacted mixture secures the ceramic particles 12 in a permanent alignment in conductor 16 so the electrical current density of the conductor is very high in the superconducting state.

To ensure relatively uniform electrical current density in conductor 16 it is necessary that ceramic particles 12 be dispersed substantially uniformly throughout the matrix composite as shown in Figures 3 and 4. One method of doing this is to place the ceramic and metal powders in a high modulus container, such as copper, ceramic or glass and attach an ultrasonic device to the container. When ultrasonic energy is applied to the container the ceramic particles will be unconstrained and allowed to rotate freely when a magnetic field is applied to the mixture. An applied magnetic field causes the ceramic particles to rotate and align in the preferred direction. The ultrasonic device is then turned off and the particle mass allowed to settle in the magnetic field. Pressure is applied as shown in Figure 4 to secure the particles in alignment and the magnetic field is turned off. A pulsating magnetic field can also aid in aligning the ceramic particles.

Thus, the present invention discloses a method for orienting superconductive crystals to increase conductivity of the composite made from ceramic powder and metal powder.

Although the best mode contemplated for carrying out the present invention has been herein shown and described, it will be apparent that modification and variation may be made without departing from what is regarded to be the subject matter of the invention.

## Claims

1. A method for orienting anisotropic superconducting crystals in a metal matrix composite to increase the electrical current carrying capacity of the composite, said method including the steps of:
mixing a superconducting ceramic powder with a metal powder;
subjecting the mixture to a high magnetic field to align particles in said ceramic powder with respect to their high critical current axes; and
pressing the aligned mixture to form a metal matrix composite with said ceramic particles in fixed alignment in a direction of the greatest critical current density.

2. A method for orienting crystals as defined in claim 1 including the further step of:
applying ultrasonic energy to said mixture to facilitate the alignment of said ceramic particles by said magnetic field prior to pressing the mixture.

3. A method for orienting crystals as defined in claim 1 wherein said metal powder includes a silver powder.

4. A method for orienting crystals as defined in claim 1 including the further step of pulsating said magnetic field to facilitate the alignment of said ceramic particles.

5. A method for orienting anisotropic superconducting crystals in a metal matrix composite to increase the electrical current carrying capacity of the composite, said method including the steps of:
mixing a superconducting ceramic powder with a metal powder;
subjecting the mixture to a high magnetic field to align particles in said ceramic powder with respect to their high critical current axes;
applying a pressure to compact the mixture; and
heating the compacted mixture to form a metal matrix composite with said ceramic particles in fixed alignment in a direction of the greatest critical current density.

6. A method for orienting crystals as defined in claim 5 including the further step of:
applying ultrasonic energy to said mixture to facilitate the alignment of said ceramic particles by said magnetic field prior to applying a pressure.

7. A method for orienting crystals as defined in claim 5 wherein said metal powder includes a silver powder.

8. A method for orienting crystals as defined in claim 5 including the further step of pulsating said magnetic field to facilitate the alignment of said ceramic particles.

# FIG_1

10

11

# FIG_2

17
16
12
15
12
12
15
18

# FIG_3

12
17
15
16
12
22
22
22
15
15
12
18

# FIG_4

12
16
12
23
24
12
25
12